(19) Europäisches Patentamt
European Patent Office
Office européen des brevets

(11) **EP 0 736 612 B2**

(12) **NEUE EUROPÄISCHE PATENTSCHRIFT**
Nach dem Einspruchsverfahren

(45) Veröffentlichungstag und Bekanntmachung des Hinweises auf die Entscheidung über den Einspruch:
**24.12.2008 Patentblatt 2008/52**

(45) Hinweis auf die Patenterteilung:
**07.07.2004 Patentblatt 2004/28**

(21) Anmeldenummer: **96104926.9**

(22) Anmeldetag: **28.03.1996**

(51) Int Cl.:
*C23C 14/34* (2006.01)
*F24J 2/48* (2006.01)
*C23C 16/30* (2006.01)
*C23C 16/02* (2006.01)
*C23C 16/50* (2006.01)
*C23C 14/06* (2006.01)
*C23C 14/02* (2006.01)
*C23C 14/00* (2006.01)

(54) **Verfahren zur Beschichtung von Sonnenkollektoren**

Process for coating solar collectors

Procédé pour le revêtement de collecteurs solaires

(84) Benannte Vertragsstaaten:
**AT CH DE DK LI NL SE**

(30) Priorität: **07.04.1995 CH 100895**

(43) Veröffentlichungstag der Anmeldung:
**09.10.1996 Patentblatt 1996/41**

(73) Patentinhaber: **Institut für Solartechnik Hochschule Rapperswil HSR 8640 Rapperswil (CH)**

(72) Erfinder:
• **OELHAFEN, Peter**
  **4056 Basel (CH)**
• **GAMPP, Roland**
  **4056 Basel (CH)**
• **GANTENBEIN, Paul, Inst. f. Solartechnik SPF**
  **8640 Rapperswil (CH)**

(74) Vertreter: **Schalch, Rainer et al c/o E. Blum & Co. Patentanwälte Vorderberg 11 8044 Zürich (CH)**

(56) Entgegenhaltungen:
**US-A- 4 309 261**

• **PIGRAM P J ET AL: "STRUCTURE AND SURFACE COMPOSITION OF SOLAR SELECTIVE GRADED STAINLESS STEEL/CARBON CERMET FILMS" APPLIED PHYSICS A. SOLIDS AND SURFACES, Bd. A52, Nr. 2, 1.Februar 1991, Seiten 145-150, XP000179932**
• **Accelerated Life Testing, IEA, 1994**
• **B. Chapman, Glow Discharge Processes, 1980, 215-221**
• **W. Munz, The Unbalalanced Magnetron, Sur. and Coatings Tech., 1991, 81-94**
• **A. Fuchs et al., Thin Solid Films, 217, (1992), 48-55**
• **T. Beerling et al., Mat. Res. Soc. Symp. Proc. Vol. 339, 203-209**

Bemerkungen:
Die Akte enthält technische Angaben, die nach dem Eingang der Anmeldung eingereicht wurden und die nicht in dieser Patentschrift enthalten sind.

**EP 0 736 612 B2**

**Beschreibung**

Die vorliegende Erfindung betrifft ein Verfahren zum Beschichten einer Unterlage für das Erzeugen eines Sonnenkollektors mit optisch selektiver Beschichtung.

Um bei der thermischen Konversion von Sonnenenergie mit Sonnenkollektoren einen hohen Wirkungsgrad zu erreichen, ist eine solar selektive Beschichtung der Kollektoren unerlässlich. Diese selektive Oberflächenbeschichtung soll eine hohe Absorption des auftreffenden Sonnenlichts und gleichzeitig eine kleine Emission von thermischer Strahlung gewährleisten. Da die Wellenlängen der elektromagnetischen Wellen von der Sonne und von der thermischen Strahlung unterschiedlich sind, kann durch einen speziellen Verlauf des Reflexionsvermögens der Oberfläche die gewünschte Selektivität erreicht werden. Das Reflexionsvermögen muss im Wellenlängenbereich des Sonnenlichts zwischen etwa 0,3 und $2\mu m$ möglichst klein und im Bereich der Infrarot-Strahlung oberhalb etwa $2\mu m$ möglichst nahe 100% sein. Gewöhnlich wird dieses Reflexionsprofil durch eine dünne Beschichtung (Dicke zwischen 0,1 und $0,2\mu m$) einer kompakten, metallischen Unterlage (meist Stahl, Kupfer oder Aluminium) realisiert. Die Beschichtung wirkt bis Wellenlängen von $2\mu m$ als Antireflexionsschicht der spiegelnden Unterlage und ist für grössere Wellenlängen im wesentlichen transparent, wodurch die hohe Reflexion der Unterlage erhalten bleibt.

Um die optischen Anforderungen an die Beschichtung zu erfüllen, ist es vorteilhaft, den Aufbau der Beschichtung so zu gestalten, dass diese unmittelbar auf der metallischen Unterlage auch metallische Eigenschaften besitzt und mit zunehmender Dicke immer dielektrischer, d.h. isolierender wird. Daher bieten sich für die Beschichtung Werkstoffe an, die aus einer Mischung von einem Isolator und einem Metall bestehen. Im sogenannten Cermet lassen sich über die Anteile von der isolierenden und der metallischen Komponente gewünschte optische Eigenschaften einstellen. Die gesamte Beschichtung kann dann entweder aus verschiedenen Lagen mit schrittweise veränderter Zusammensetzung oder aus einer einzigen Lage mit einem kontinuierlichen Verlauf der Konzentration aufgebaut werden.

Bisher werden in den handelsüblichen Kollektoren die selektiven Beschichtungen meist galvanisch aufgebracht. Die nasschemischen Methoden besitzen aber den Nachteil, dass bei der Produktion umweltschädigende Säurerückstände anfallen können und die Reproduzierbarkeit der Schichteigenschaften nicht immer gewährleistet ist. Mit moderneren vakuumtechnischen Abscheidemethoden, wie dem Kathodenzerstäuben (Sputtern) können diese Nachteile umgangen werden. Beim konventionellen Sputtern wird einer Vakuumkammer, die ausgestattet ist mit einer Kathode, einer Anode und dem zu beschichtenden Substrat, ein Inertgas zugeführt und ein gewisser Arbeitsdruck (gewöhnlich zwischen 0,1Pa und 10Pa) eingestellt. Durch das Anlegen einer Gleichspannung (DC) oder einer hochfrequenten Wechselspannung (RF) zwischen Kathode und Anode, zündet ein Plasma, aus dem Ionen extrahiert und auf die Kathode beschleunigt werden. Die auf die Kathode auftreffenden energetischen Ionen schlagen (sputtern) Atome aus der Kathodenoberfläche, die mit einem Target aus einem spezifischen Material versehen ist. Die abgesputterten Atome bilden schliesslich eine Beschichtung auf dem Substrat. Bei einer Erweiterung dieser Methode, dem reaktiven Sputtern, wird zusätzlich zum Inertgas ein reaktives Gas (z.B. $O_2$, $N_2$ oder $H_2$) zugeführt. Zwischen Komponenten des Reaktivgases und des Targetmaterials können dann chemische Reaktionen eingegangen und Verbindungen in die Schicht eingebaut werden. Oftmals sind an der Kathode auch Magnete angebracht, so dass das Plasma im Magnetfeld eingeschlossen und vor dem Target konzentriert wird. In diesem Fall spricht man von Magnetronsputtern.

In G. Harding et al, Method of and apparatus for reactively sputtering a graded surface coating onto a substrate, United States Patent 4 309 261 vom 5. Januar 1982 ist eine reaktive DC-Sputter-Depositmethode samt Anlage beschrieben, um evakuierte Röhrenkollektoren mit einer Isolator-Metall-Mischung und kontinuierlichem Konzentrationsverlauf zu beschichten. Unter Verwendung von amorphem Kohlenwasserstoff als Isolator und rostfreiem Stahl als Metall werden diese Röhrenkollektoren von der Firma Shiroky, Japan hergestellt und z.B. von der Firma Cuenod, Satigny, GE kommerziell vertrieben.

Zum Stand der Technik sei im übrigen auf die folgenden Literaturstellen verwiesen:

- R.A. Haefer, Oberflächen- und Dünnschicht-Technologie, Teil I Beschichtungen von Oberflächen, Springer-Verlag, Berlin, Heidelberg, New York, 1987.
- C.P. Klages, R. Memming, Microstructure and physical properties of metal-containing hydrogenated carbon films, in Properties and characterization of amorphous carbon films, Materials Science Forum Vols. 52 & 53 (1989), Trans. Tech. Publications, Aedermannsdorf, Seiten 609-644.
- B. Carlsson et al., Accelarated Life Testing of Solar Energy Materials, Case study of some selective solar absorber coating materials for DHW Systems, A Report of Task X Solar Materials Research and Development, February 1994, IEA International Energy Agency.
- W.D. Münz, The unbalanced magnetron: current status of development, Surface and Coatings Technology 48 (1991) 81 - 94 beschreibt eine Vorrichtung zur Herstellung von PVD-Beschichtungen und Anwendungen dieser Vorrichtung zum Herstellen von TiN- und TiAlN-Schichten.
- B. N. Chapman, Glow discharge processes, John Wiley & Sons Inc., Seiten 215 - 221 beschreibt unterschiedliche Anordnungen zur Herstellung von Beschichtungen.

- P.J. Pigram, R.N. Lamb, B.J. Wood und R.E. Collins, *Structure and Surface Composition of Solar Selective Graded Stainless Steel/Carbon*, Appl. Phys. A 52 (1991), 145 - 150, beschreiben ein Verfahren zum Beschichten von Rohren mit einer antireflektiven Beschichtung.

Im übrigen sei auf diverse Prospekte von Sonnenkollektorfirmen verwiesen.

Da der Preis von evakuierten Röhrenkollektoren hoch und deren Wartung kompliziert ist, ist es erstrebenswert auch in den preiswerteren und einfachen Flachkollektoren vakuumtechnisch hergestellte Beschichtungen einzusetzen. Bei Flachkollektoren stellen sich aber neben den Anforderungen an die optische Selektivität auch sehr hohe an die Alterungsbeständigkeit, denn in diesen herrschen sehr korrosive Umgebungsbedingungen. Die Kollektorbeschichtung muss an Luft sowohl hohen Temperaturen (typischerweise etwa 60°C, Spitzenwerte bis zu 200°C) als auch Feuchte widerstehen, damit es innerhalb eines Zeitraumes von mindestens 25 Jahren zu keiner untolerierbaren Abnahme des Wirkungsgrades kommt. Das nach der Methode von Harding hergestellte Beschichtungsmaterial ist unter diesen Bedingungen nicht hinreichend stabil. Aber selbst die Stabilität des Schichtmaterials alleine genügt noch nicht. In Kombination mit dem Kollektorblech treten zusätzliche Alterungsmechanismen auf, die die Lebensdauer eines Kollektors einschränken. Beispielsweise kann das Metall, aus dem das Kollektorblech besteht, durch die Beschichtung diffundieren, an die Oberfläche gelangen und oxidieren. Die Gefahr einer solchen Diffusion ist bei gewalzten Blechen, die in der technischen Anwendung üblich sind, besonders gross. Auf diesen sind bis zu einige $\mu$m tiefe Walzriefen vorhanden, deren Kanten durch die Beschichtung nur unvollständig abgedeckt werden. An diesen Kanten findet deshalb bevorzugt Diffusion statt.

Es ist daher aufgrund der obigen Ausführungen eine Aufgabe der vorliegenden Erfindung vakuumtechnisch beschichtete Kollektoren zu schaffen mit ausreichender Beständigkeit und hoher optischer Selektivität.

Die erfindungsgemäss gestellte Aufgabe wird mittels eines Verfahrens gemäss dem Wortlaut nach Anspruch 1 gelöst. Vorgeschlagen wird ein Verfahren zum Beschichten eines Substrates für die Herstellung eines Sonnenkollektores, indem ein Prozess aus RF plasmaaktivierter Gasphasendeposition von einem Kohlenwasserstoffgas resp. fluoriertem Kohlenwasserstoffgas mit dem Sputtern eines Chromtargets und der Verwendung eines Metallsubstrats kombiniert wird. Dabei ist es für die Alterungsbeständigkeit der Schichten wichtig, dass die Beschichtung mindestens 50 Atomprozent Chrom an der Substratoberfläche aufweist und die Unterlage bzw. das Substrat während der Deposition auf einem negativen, elektrischen Potential (Bias) gehalten wird. Zusätzlich erweist es sich besonders für die Stabilität bei hohen Temperaturen an Luft als vorteilhaft, wenn das Substrat bzw. die Beschichtung während des Herstellprozesses beheizt wird.

Im Unterschied zum Verfahren von G.L. Harding et al. wird ein elektrisches Potential am Substrat angelegt. Bei Kontakt des Substrates mit dem Plasma werden durch das Potentialgefälle zwischen Plasma und Substrat Ionen aus dem Plasma extrahiert und auf das Substrat hin beschleunigt. Die am Substrat auftreffenden Ionen tragen wesentlich zum gesamten Energieeintrag in die wachsende Schicht bei, und es entsteht die spezielle Schichtstruktur.

Weitere bevorzugte Ausführungsvarianten des erfindungsgemässen Verfahrens sind in den abhängigen Ansprüchen 2 bis 8 charakterisiert.

Die erfindungsgemäss hergestellte Beschichtung des Sonnenkollektors enthält amorphen Kohlenwasserstoff resp. fluorierten amorphen Kohlenwasserstoff und von einem Target abgesputtertes Metall, wobei die Beschichtung aus verschiedenen Lagen mit schrittweise veränderter Zusammensetzung und/oder aus mindestens einer Lage mit einem wenigstens nahezu kontinuierlichen Verlauf der Konzentration besteht, wobei die Chromkonzentration in der Beschichtung nahe an der Unterlage bzw. der Substratoberfläche mindestens 50 Atomprozent beträgt und an der Oberfläche der Beschichtung bzw. des Sonnenkollektors weniger als 30 Atomprozent. Damit ist es auch möglich, dass einzelne Lagen als Diffusionsbarrieren und/oder Haftvermittler wirken. Eine derartige Diffusionsbarriere bzw. Haftungsvermittlerschicht kann die direkt auf der Unterlage aufliegende, erste, metallreiche Lage sein. Dabei ist es technologisch vorteilhaft, dass für die Erzeugung dieser Diffusionsbarrieren bzw. Haftungsvermittlerschichten keine zusätzliche Beschichtungsmethoden notwendig sind. Im Falle von verschiedenen Lagen mit unterschiedlicher Schichtzusammensetzung kann es auch vorteilhaft sein, wenn sich die Zusammensetzung an den jeweiligen Lagengrenzschichten nicht sprunghaft sondern stetig ändert.

Die Erfindung wird nun anschliessend anhand der beigefügten Figuren sowie anhand von Ausführungsbeispielen näher erläutert.

Dabei zeigt:

Fig. 1 eine beispielsweise ausgebildete Depositionsanlage, währenddem

Fig. 2 unter Bezug auf Ausführungsbeispiel 3 den Zeitverlauf von Depositionsparametern darstellt.

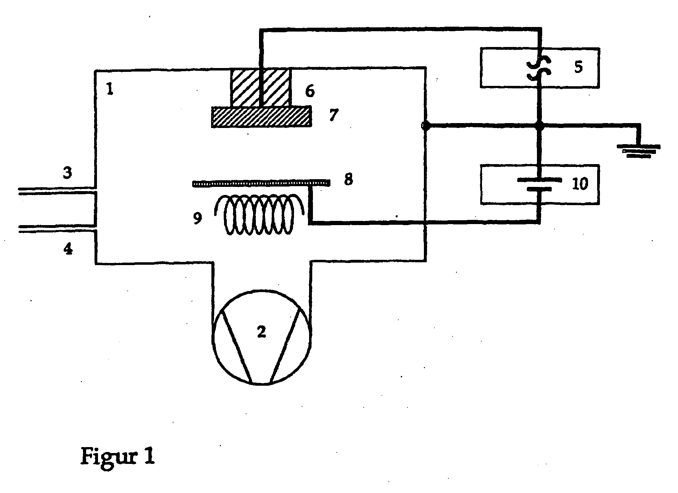

In Figur 1 ist eine Depositionsanlage mit ihren wesentlichen Komponenten schematisch und stark vereinfacht dargestellt. 1 ist das Vakuumgehäuse der Anlage und 2 das zur Aufrechterhaltung des Vakuums notwendige Pumpsystem. 3 und 4 stellen die Zuleitungen für das Inertgas resp. Kohlenwasserstoffgas resp. fluoriertem Kohlenwasserstoffgas dar, deren Zustrom durch geeignete Kontroll- und Messgeräte gesteuert wird. 5 ist das Netzteil für die hochfrequente Wechselspannung, die über kapazitive oder induktive Kopplung auf die Kathode 6 übertragen wird. Es ist möglich, aber nicht unbedingt notwendig, die Kathode als Magnetron auszuführen. Auf der Kathode befindet sich das Metalltarget 7, das aus reinen Metallen aber auch Metallegierungen bestehen kann. 8 stellt die zu beschichtende Unterlage dar, nämlich das Kollektorblech. Die Unterlage wird während des Beschichtungsprozesses mit einer Heizung 9 geheizt und über eine Gleichspannungsquelle 10 auf einem negativen elektrischen Potential (Bias) gehalten. In dieser Anordnung stellen die Vakuumkammerwände die Anode dar.

Beispielsweise mögliche Kombinationen von Kohlenwasserstoffgasen, fluoriertem Kohlenwasserstoffgas und Metalltargets sind in der nachfolgenden Tabelle 1 aufgeführt:

Tabelle 1:

| Beispielsweise mögliche Materialkombinationen aus Kohlenwasserstoffgas, fluoriertem Kohlenwasserstoffgas und Metalltarget. | |
| --- | --- |
| Kohlenwasserstoffgas, resp. fluoriertem Kohlenwasserstoffgas | Metalltarget |
| Methan | Chrom |
| Azetylen | Chrom |
| Methan | Titan |
| Azetylen | Titan |
| Difluoromethan | Chrom |
| Difluoromethan | Titan |
| Tetrafluoromethan | Chrom |
| Tetrafluoromethan | Titan |

Das Material, das in diesem Beschichtungsprozess abgeschieden wird, besteht aus amorphem Kohlenwasserstoff (in der Literatur auch a-C:H oder diamantähnlicher Kohlenstoff genannt) oder fluoriertem Kohlenwasserstoff (a-C:H:F) und vom Target abgesputterten Metall. Falls das Metall aus einem Karbidbildner besteht, wird es bis zu sehr hohen Metallkonzentrationen (typischerweise mehr als 50 Atomprozent) in Form von Metallkarbidpartikeln in die amorphe Kohlenwasserstoffmatrix resp. fluorierte Kohlenwasserstoffmatrix eingebaut. Ueber die Anteile von Kohlenwasserstoffgas resp. fluoriertem Kohlenwasserstoffgas und Inertgas, lässt sich der Metallgehalt einer abgeschiedenen Lage einstellen. Die Alterungsstabilität der Beschichtung hängt empfindlich von der Stabilität des Metallkarbids und der amorphen Kohlenwasserstoffmatrix resp. fluorierte Kohlenwasserstoffmatrix ab. Weiterhin ist wichtig, dass keine unerwünschten Diffusionsprozesse von Substratmaterial in und durch die Beschichtung noch von Beschichtungsmaterial in das Substrat stattfinden. Besonders in feuchter Atmosphäre erweist sich auch die Haftung der Beschichtung auf dem Substrat als wesentlicher Parameter für die Alterungsbeständigkeit.

Durch das negative elektrische Potential der Unterlage lässt sich die Maximalenergie, mit der aus dem Plasma extrahierte Ionen auf die wachsende Schicht treffen, einstellen. Der Ionenbeschuss führt, wie auch bei reinen amorphen Kohlenwasserstoffilmen bekannt, zu einer Verdichtung der Schicht. Damit lässt sich die Härte und Dichte der Schichten vergrössern und das Ausbilden von Poren einschränken. Somit wird mit geeigneter Bias-Spannung bzw. geeignetem, negativen, elektrischen Potential die Alterungsbeständigkeit der Beschichtung wesentlich verbessert. Durch das Variieren des negativen elektrischen Potentials bzw. der Bias-Spannung des Substrates bzw. der Unterlage kann aber auch die Zusammensetzung der Beschichtung beeinflusst werden, als mit erhöhtem, negativen, elektrischen Potential eine Erhöhung der Metallkonzentration in der Beschichtung erzielt werden kann. Durch das Heizen der Unterlage wird zudem der Einbau von schwach gebundenem Wasserstoff in die amorphe Kohlenwasserstoffmatrix resp. fluorierte Kohlenwasserstoffmatrix verringert.

Die Beschichtung, bestehend aus den verschiedenen Schichtlagen, oder aufweisend einen im wesentlichen kontinuierlichen Verlauf der Konzentration, wird so gewählt, dass ein selektives Reflexionsprofil erzielt wird und zusätzlich einzelne Lagen oder Bereiche der Beschichtung als Diffusionsbarrieren und Haftungsvermittler wirken.

Anhand konkreter Beispiele soll gezeigt werden, wie mit der beschriebenen Methode optisch selektive Beschichtungen hoher Alterungsbeständigkeit hergestellt werden können. Bei den folgenden Beispielen können die Schichten durch eine optimale Wahl von Lagendicke und -zusammensetzung hinsichtlich ihrer optischen Kennzahlen weiter verbessert werden. Die Vakuumapparatur, in der die Bleche eingebracht worden sind, ist vor der Beschichtung auf einen Enddruck von etwa 1 · 10$^{-4}$Pa evakuiert worden. Gearbeitet wurde mit Methan und Argon als Prozessgas und einem Chromtarget. Das Target mit Durchmesser 90mm war auf einem Magnetron angebracht und wurde über eine kapazitive Kopplung von einem RF Netzteil (13,56MHz und 200W) gespeist. Während der Beschichtung wurde das Blech auf einem elektrischen Potential von -200V gehalten. Die weiteren Beschichtungsparameter sind bei den einzelnen Beispielen aufgeführt.

Um die Alterungsbeständigkeit zu charakterisieren, wurden die Beschichtungen von der Solarenergie Prüf- und Forschungsanstalt SPF am Interkantonalen Technikum in Rapperswil in künstlichen Umgebungen, die ein Vielfaches der natürlichen Belastung simulieren, beschleunigt gealtert.

Ausführungsbeispiel 1 (nicht zur Erfindung gehörend):

**Verfahren zur Herstellung einer Zweilagenschicht:**

Eine Zweilagenschicht wurde mittels der Parameter, angeführt in der Tabelle 2, hergestellt. Als Unterlage wurde technisches Kupferblech mit einer typischen mittleren Rauhigkeit (RMS Rauhigkeit) von etwa 0,10$\mu$m verwendet. Dabei zeigt die erste Lage direkt das Substrat bzw. das Kupferblech, überdeckend einen Metallgehalt von 54 Atomprozent Chrom, währenddem Lage 2, die Oberfläche des Kollektors bildend, einen Metallgehalt von 32 Atomprozent Chrom aufweist. Für die selektive Beschichtung ist es also wesentlich, den Metallgehalt der Schicht so zu gestalten, dass sie an der Grenze zur metallischen Unterlage bzw. dem Substrat eine hohe Metallkonzentration im Bereich von ca. 40 - 60 Atomprozent und an der Oberfläche des Kollektors einen kleinen Metallgehalt besitzt. Damit ist das Metall an der Substratoberfläche fast vollständig karbidisiert und der Anteil der Kohlenwasserstoffmatrix klein; an der Schichtoberfläche des Kollektors hingegen liegt dagegen fast ausschliesslich die Kohlenwasserstoffmatrix vor. Die erste, metallreiche Lage, fast völlig aus Chromkarbid bestehend, dient im weiteren als Haftungsvermittler zwischen der Beschichtung und der zu beschichtenden, metallischen Unterlage.

Die gemäss Tabelle 2 hergestellte Zweilagenschicht wurde während 150 Stunden bei 300°C an Luft beschleunigt gealtert, um die Stabilität bei hohen Temperaturen an Luft zu charakterisieren. Aus dem Reflexionsverlauf wurde vor der Alterungsbehandlung ein solares Absorptionsvermögen von 66,5% und eine thermische Emissivität von 10,9% (bei einer angenommenen Kollektortemperatur von 100°C) bestimmt. Nach der thermischen Behandlung verbesserte sich das solare Absorptionsvermögen sogar auf 71,6% und verschlechterte sich die thermische Emissivität nur leicht und stieg auf einen Wert von 12,0%. Da sowohl diese integralen Kennzahlen als auch das Reflexionsprofil der Kollektorbeschichtung bei der beschleunigten Alterung bei 300°C an Luft im wesentlichen konstant blieben, kann gefolgert werden, dass die Beschichtung bei den in Flachkollektoren üblichen Betriebstemperaturen eine sehr hohe Lebensdauer besitzen würden. Die grosse Stabilität der Kollektoroberfläche hat zweierlei Ursachen. Zum einen ist jede der einzelnen Lagen sehr stabil und hart. Wird eine Lage auf einer Siliziumeinkristall-Oberfläche abgeschieden, dann kann sie mit einer Stahlspitze nicht angekratzt werden. Zum anderen wirkt die erste Lage, die sehr metallreich ist, also einen hohen Anteil Chromkarbid aufweist, als Barriere gegen die Diffusion von Kupfer. Rasterkraftmikroskopische Untersuchungen zeigten bei Schichten, die unter diesen Bedingungen hergestellt wurden, dass die Oberflächen sehr flach sind und keine Poren besitzen. Dadurch kann kein Kupfer aus der Unterlage entlang von Poren an die Schichtoberfläche diffundieren. Ausserdem ist die Lage, da die Chromkarbid-Kristallite Durchmesser von nur wenigen Nanometern besitzen, quasi amorph. Im Gegensatz zu feinkristallinen Lagen tritt damit keine Korngrenzendiffusion auf. Die Dicke der ersten Lage wurde an die Rauhigkeit des verwendeten Kupferbleches angepasst, so dass die Kanten der Walzrillen hinreichend abgedeckt werden.

Tabelle 2:

| Beschichtungsparameter für die einzelnen Lagen der selektiven Beschichtung gemäss Ausführungs-beispiel 1. | | |
|---|---|---|
| Beschichtungsparameter | Lage 1 | Lage 2 |
| Argon Volumenstrom [sccm] | 40 | 40 |
| Methan Volumenstrom [sccm] | 1,0 | 1,5 |
| Druck [Pa] | 0,8 | 2,6 |
| Substrattemperatur [°C] | 200 | 200 |
| Metallgehalt[Atomprozent Chrom] | 54 | 32 |
| Dicke [$\mu$m] | 0,056 | 0, 055 |

Ausführungsbeispiel 2:

**Herstellung einer Dreilagenschicht:**

Durch eine zusätzliche dritte Lage, aufweisend einen noch wesentlich geringeren Metallgehalt von < 10 Atomprozent Metall, lässt sich der optische Wirkungsgrad der Kollektorbeschichtung weiter verbessern. In Tabelle 3 sind die Parameter aufgeführt, mit denen a-C:H/Cr-Dreilagenschichten hergestellt worden sind, die vor den Alterungsbehandlungen ein solares Absorptionsvermögen $\alpha_S$ von etwa 89% und eine thermische Emissivität $\varepsilon_{100°C}$ von etwa 14% aufweisen (siehe Tabelle 4). Als Unterlage wurde wiederum technisches Kupferblech mit einer typischen mittleren Rauhigkeit (RMS Rauhigkeit) von 0,10 $\mu$m verwendet.

Tabelle 3:

| Parameter für die einzelnen Lagen der selektiven Beschichtung gemäss Ausführungsbeispiel 2. | | | |
|---|---|---|---|
| Parameter | Lage 1 | Lage 2 | Lage 3 |
| Argon Volumenstrom [sccm] | 40 | 40 | 40 |
| Methan Volumenstrom [sccm] | 1,0 | 1,75 | 4,0 |
| Druck [Pa] | 0,8 | 2,8 | 3,2 |
| Substrattemperatur [°C] | 200 | 200 | 200 |
| Metallgehalt[Atomprozent Chrom] | 54 | 24 | 5 |
| Dicke [$\mu$m] | 0,056 | 0,080 | 0,050 |

An diesen Dreilagenschichten wurden beschleunigte Alterungsuntersuchungen in feuchter Atmosphäre (Proben 1 und 2) und unter UV-Bestrahlung (Proben 3 und 4) durchgeführt. Wie in Tabelle 4 wiedergegeben ist, führte keine der Behandlungen zu einer signifikanten Verschlechterung der optischen Kennzahlen. Die Feuchtebehandlungen sind bezeichnet durch die Behandlungsdauer und die Lufttemperatur / relative Luftfeuchtigkeit / Probentemperatur. Selbst während 70h bei den ausgesprochen korrosiven Bedingungen einer 85°C heissen Luftatmosphäre mit 95% relativer Luftfeuchtigkeit und einer Probentemperatur von 80°C verschlechterten sich die Kennzahlen von Probe 2 nicht. Da die Temperatur der Proben unterhalb der Lufttemperatur liegt, sind die Proben während der Alterungsbehandlung vollständig mit Kondenswasser bedeckt. Dass die Eigenschaften dieser Beschichtungen durch Feuchteeinfluss nicht verschlechtert werden, liegt neben der geringen Porösität der Schichten und damit geringen Permeabilität für Wasser an der Haftungsvermittlung durch die erste, metallreiche Lage.

Mit den Bestrahlungstests kann geprüft werden, ob die a-C:H/Cr-Kollektorbeschichtung empfindlich auf UV-Strahlung reagiert. (Für den UV-Test wurde eine UV400F Lampe von Dr. Hönle verwendet. Mit dieser Lampe wurde auf die Proben das 3,5-fache der UV-A-Strahlung und das 6,5-fache der UV-B-Strahlung verglichen mit dem Tageslichtspektrum D65 eingestrahlt). Während des Tests der UV-Beständigkeit wurde Probe 3 auf 50°C gekühlt und Probe 4 nicht gekühlt. Letztere erwärmte sich dadurch auf eine Temperatur von 75°C. Die solare UV-Einstrahlung wird zwar durch die bei Flachkollektoren übliche Glasabdeckung reduziert, doch konnte nicht von vornherein ausgeschlossen werden, dass photochemische Reaktionen die optischen Eigenschaften der a-C:H/Cr-Beschichtungen ungünstig beeinflussen. Die Untersuchungen ergeben jedoch, dass durch die UV-Einstrahlung keine wesentliche Veränderung der optischen Eigenschaften eintritt. Es kann daher der Schluss gezogen werden, dass weder bei Kondensations- noch bei UV-Belastung eine signifikante Degradation der selektiven Eigenschaften zu erwarten ist.

Tabelle 4:

| Solarer Absorptionsgrad $\alpha_S$ und thermische Emissivität $\varepsilon_{100°C}$ von Dreilagenschichten gemäss Ausführungsbeispiel 2 vor und nach verschiedenen Alterungsbehandlungen | | | | | |
|---|---|---|---|---|---|
| Probe | ungealtert | | Behandlung | gealtert | |
| | $\alpha_S$ | $\varepsilon_{100°C}$ | | $\alpha_S$ | $\varepsilon_{100°C}$ |
| 1 | 89,3% | 14,8% | 200h bei 60°C/ 95%/55°C | 88,7% | 13,3% |
| 2 | 89,2% | 14,4% | 70h bei 85°C/ 95%/80°C | 89,4% | 13,1% |

(fortgesetzt)

| Solarer Absorptionsgrad $\alpha_S$ und thermische Emissivität $\varepsilon_{100°C}$ von Dreilagenschichten gemäss Ausführungsbeispiel 2 vor und nach verschiedenen Alterungsbehandlungen | | | | | |
|---|---|---|---|---|---|
| Probe | ungealtert | | Behandlung | gealtert | |
| | $\alpha_S$ | $\varepsilon_{100°C}$ | | $\alpha_S$ | $\varepsilon_{100°C}$ |
| 3 | 88,7% | 13,2% | 86h UV bei 50°C | 89,0% | 13,1% |
| 4 | 88,9% | 13,0% | 86h UV bei 75°C | 88,9% | 13,1% |

Ausführungsbeispiel 3:

**Herstellung von quasi kontinuierlichen Dreilagenschichten**

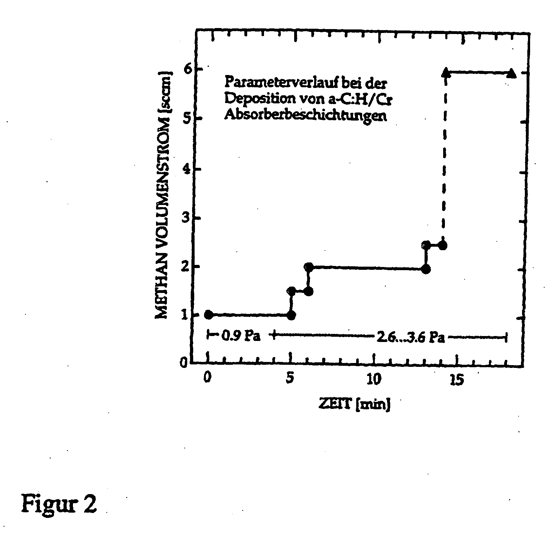

Um den solaren Absorptionsgrad weiter zu erhöhen, wurden a-C:H/Cr-Dreilagenbeschichtungen hergestellt, bei denen der Metallgehalt der einzelnen Lagen quasi kontinuierlich ineinander übergeht. Bei den oben aufgeführten Ausführungsbeispielen wurde das Target zwischen der Abscheidung der einzelnen Lagen während mehreren Minuten auf die neuen Parameter konditioniert, ohne in dieser Zeit das Substrat zu beschichten. Dagegen wird bei der quasi kontinuierlichen Dreilagenbeschichtung das Substrat auch unmittelbar nach einer Parameteränderung weiterbeschichtet. Da das Target nach einer Parameteränderung erst nach einiger Zeit wieder in einen stabilen Zustand gelangt, in dem sich Deposition und Resputtern von Kohlenwasserstoff an der Targetoberfläche die Waage halten, ändert sich zwischen den Lagen die Schichtzusammensetzung nicht sprunghaft sondern stetig. Der genaue Zeitverlauf der Depositionsparameter Methan-Volumenstrom und Druck ist in Figur 2 gezeigt. Mit der senkrechten gestrichelten Linie bei einer Zeit von 14 min ist eine Konditionierungsphase gekennzeichnet (10 min Dauer). Während der gesamten Abscheidung beträgt der Argon-Volumenstrom 40 sccm und die Substrattemperatur 300°C. Näherungsweise lässt sich der Aufbau der entstehenden Beschichtung als Abfolge dreier homogener Lagen beschreiben. Die erste Lage besteht aus einer etwa 0,028$\mu$m dicken chromkarbidreichen Zwischenschicht (54 Atomprozent Chrom), die als Diffusionsbarriere und Adhäsionsvermittler wirkt. Bei der geringen Oberflächenrauhigkeit der bei diesen Proben verwendeten, mechanisch polierten Kupfersubstrate genügt diese Dicke, um die präferentielle Diffusion entlang den Walzrillen des Bleches zu unterdrücken (RMS Rauhigkeit von 0,07$\mu$m). Die zweite Lage besteht aus einer etwa 0,060$\mu$m dikken a-C:H/Cr-Schicht mit 15 Atomprozent Chrom und die letzte Lage aus einer 0,072$\mu$m dicken, reinen a-C:H-Deckschicht. Der solare Absorptionsgrad der quasi kontinuierlichen Dreilagenschichten beträgt etwa 92%, die thermische Emissivität 8,6% (siehe Tabelle 5).

Anhand dreier Proben (Proben 5 bis 7), die nach dem Profil in Figur 2 hergestellt worden sind, wurde abgeschätzt, ob mit den a-C:H/Cr-Beschichtungen die Qualifikationskriterien der International Energiy Agency IEA erfüllt werden können (siehe Literaturliste). Eine Kollektorbeschichtung gilt als qualifiziert, falls sich innerhalb von 25 Jahren in einem Standard-Kollektor die optischen Kennzahlen $\alpha_S$ und $\varepsilon_{100°C}$ voraussichtlich so wenig ändern werden, dass das Kriterium

$$-\Delta\,\alpha_S + 0{,}25\,\Delta\varepsilon_{100°C} \leq 5\%$$

erfüllt bleibt. Um die Kinematik der Alterungsprozesse zu untersuchen, wurden die Proben bei verschiedenen erhöhten Temperaturen bis zu ihrem Versagen, das heisst bis das Qualifikationskriterium nicht mehr erfüllt ist, getempert. In Tabelle 5 sind die Kennzahlen der Proben 5 bis 7 und die Lebensdauern beim Tempern an Luft wiedergegeben.

Tabelle 5:

| Solarer Absorptionsgrad $\alpha_S$ und thermische Emissivität $\varepsilon_{100°C}$ von quasi kontinuierlichen Dreilagenschichten gemäss Ausführungsbeispiel 3 vor der Temperbehandlung und deren Lebensdauer bei erhöhter Temperatur | | | | |
|---|---|---|---|---|
| Probe | $\alpha_S$ | $\varepsilon_{100°C}$ | Temperatur | Lebensdauer |
| 5 | 91,8% | 8,4% | 250°C | 80....120h |
| 6 | 91,8% | 8,8% | 300°C | <20h |
| 7 | 91,8% | 8,6% | 220°C | >280h |

Die Lebensdauer der quasi kontinuierlichen Dreilagenschichten beträgt bei 250°C zwischen 80 und 120h, bei 300°C weniger als 20h und bei 220°C mehr als 280h. Anhand von Zeittransformationsfunktionen kann geschlossen werden, dass die Gebrauchsdauer unter den thermischen Belastungen in einem Standard-Kollektor mindestens 25 Jahre betragen sollte. Die Beschichtung erfüllt damit die Qualifikationskriterien der IEA.

Bei der in Figur 1 beispielsweise dargestellten Depositionsanlage sowie den Ausführungsbeispielen 2 und 3 handelt es sich um Beispiele, um die Erfindung näher zu erläutern und verständlich zu machen. Selbstverständlich ist die Erfindung nicht auf die dargestellte Anlage und die Ausführungsbeispiele beschränkt. So können anstelle von Methan auch andere Kohlenwasserstoffgase resp. fluorierte Kohlenwasserstoffgase verwendet werden, und anstelle von Chrom können andere Metalle verwendet werden, um in der Beschichtung miteingeschlossen zu werden.

Erfindungswesentlich ist, dass bei der Beschichtung eines Substrates bzw. einer Unterlage zur Herstellung eines Sonnenkollektors plasmaaktivierte Gasphasendeposition mit einem Zerstäubungsprozess und negativem Substratpotential kombiniert wird.

**Patentansprüche**

1. Verfahren zum Beschichten einer metallischen Unterlage bzw. eines metallischen Substrats beim Herstellen eines Sonnenkollektors, wobei das Beschichten mittels eines kombinierten CVD/PVD-Prozesses erfolgt, bei welchem eine plasmaaktivierte Gasphasendeposition von einem Kohlenwasserstoffgas resp. fluoriertem Kohlenwasserstoffgas und ein Sputtern eines Chromtargets stattfindet und eine amorphen Kohlenwasserstoff oder fluorierten amorphen Kohlenwasserstoff enthaltende Beschichtung gebildet wird, wobei verschiedene Lagen mit schrittweise verändertem Chromgehalt und/oder mindestens eine Lage mit einem wenigstens nahezu kontinuierlichen Verlauf des Chromgehalts aufgebracht werden, **dadurch gekennzeichnet, dass** die Unterlage bzw. das Substrat während dem Beschichten über eine Gleichspannungsquelle (10) auf einem negativen elektrischen Potential gehalten wird, zum Einstellen einer Maximalenergie von aus dem Plasma extrahierten Ionen, dass die Unterlage ein Kupferblech ist und dass der Chromgehalt in der Beschichtung von der Substratoberfläche zur Oberfläche der Beschichtung von über 50 Atomprozent auf weniger als 30 Atomprozent abnimmt.

2. Verfahren nach Anspruch 1, **dadurch gekennzeichnet, dass** das Beschichten in einer evakuierten Depositionsanlage (1) erfolgt, wobei während des Beschichtens durch Aenderung der Konzentration des Kohlenwasserstoff-, bzw. fluorierten Kohlenwasserstoff-, Volumenstromes in einem Inertgasvolumenstrom in der Anlage die Zusammensetzung der Beschichtung bei zunehmender Schichtdicke verändert wird.

3. Verfahren nach einem der vorangehenden Ansprüche, **dadurch gekennzeichnet, dass** die Zusammensetzung in der Beschichtung bei fortschreitendem Beschichtungsvorgang verändert wird, indem das negative elektrische Potential des Substrates bzw. der Unterlage variiert bzw. verändert wird.

4. Verfahren nach einem der Ansprüche 1 bis 3, **dadurch gekennzeichnet, dass** die Unterlage bzw. das Substrat während des Beschichtungsvorganges geheizt wird.

5. Verfahren nach einem der Ansprüche 1 bis 4, **dadurch gekennzeichnet, dass** der Metallgehalt in der Beschichtung von der Substrat- bzw. Unterlageoberfläche zur Oberfläche der Beschichtung abnehmend eingestellt wird, indem zu Beginn des Beschichtungsprozesses mit einem niedrigeren Volumenstrom an Kohlenwasserstoffgas, wie fluoriertem Kohlenwasserstoffgas, gearbeitet wird, der während des Prozesses entweder stufenartig oder kontinuierlich erhöht wird und/oder indem das negative elektrische Potential an der Unterlage bzw. dem Substrat während des fortlaufenden Beschichtungsprozesses verringert wird.

6. Verfahren nach einem der Ansprüche 1 bis 5, **dadurch gekennzeichnet, dass** das Kupferblech in einer evakuierten Depositionsanlage beschichtet wird, indem an einer Kathode das aus Chrom oder einer Chromlegierung bestehendes Target mittels Kathodenzerstäubung abgebaut bzw. abgesputtert wird und ein mit einem Kohlenwasserstoff, wie beispielsweise Methan, beaufschlagtes Inert- oder Trägergas, wie beispielsweise Argon, in die Anlage eingeführt wird, wobei hochfrequente Wechselspannung über kapazitive oder induktive Koppelung auf die Kathode übertragen wird.

7. Verfahren nach einem der Ansprüche 1 bis 6, **dadurch gekennzeichnet, dass** das Kohlenwasserstoffgas resp. fluorierte Kohlenwasserstoffgas ausgewählt ist aus der Gruppe umfassend Methan, Azetylen, Difluoromethan und Tetrafluoromethan.

**8.** Verfahren nach einem der Ansprüche 1 bis 7, **dadurch gekennzeichnet, dass** durch Aenderung der Zusammensetzung einzelne Schichten erzeugt werden, welche als Diffusionsbarrieren und/oder als Haftungsvermittler innerhalb der Beschichtung und/oder gegenüber der zu beschichtenden Unterlage wirken.

## Claims

**1.** Method for coating a metallic support or a metallic substrate in the production of a solar collector, wherein the coating is carried out by means of a combined CVD-PVD process, in which a plasma activated gas phase deposition from a hydrocarbon gas or from a fluorinated hydrocarbon gas and a sputtering of a chrome target takes place and a coating comprising amorphous hydrocarbon or fluorinated amorphous hydrocarbon is formed, wherein different layers with a step-wise changing chrome content and/or at least one layer with an at least nearly continuous change of the chrome contents are applied, **characterised in that** the support or substrate is held on a negative electric potential by means of a DC voltage source (10) during coating for adjusting a maximum energy of ions extracted from the plasma, that the substrate is a copper sheet and that the chrome content in the coating decreases from the surface of the substrate to the surface of the coating from at least 50 atom percent to less than 30 atom percent.

**2.** Method of claim 1, **characterised in that** the coating is carried out in an evacuated depositioning plant (1), wherein, during coating, the composition of the coating is changed with increasing coating thickness by means of a change of the concentration of the hydrocarbon or fluorinated hydrocarbon gas volume flow in an inert gas volume flow in the plant.

**3.** Method of any of the preceding claims **characterised in that** the composition in the coating is changed with advancing coating process by varying or changing the negative electric potential of the substrate or support.

**4.** Method of any of the claims 1 to 3 **characterised in that** the support or substrate is heated during the coating process.

**5.** Method of any of the claims 1 to 4, **characterised in that** the metal content of the coating is adjusted to decrease from the substrate or support surface to the surface of the coating by working at the beginning of the coating process with a low volume flow of hydrocarbon gas or fluorinated hydrocarbon gas, which is increased either in steps or continuously during the process, and/or by decreasing the netagive electric potential of the support or substrate during the advancing coating process.

**6.** Method of any of the claims 1 to 5 **characterised in that** the copper sheet is coated in an evacuated depositioning plant by sputtering off the target of chrome or a chrome alloy at a cathode by means of cathode sputtering and by introducing a inert gas or carrier gas into the plant, such as argon, with the addition a hydrocarbon, such as methane, wherein high frequency AC voltage is applied to the cathode by means of capacitive or inductive coupling.

**7.** Method of any of the claims 1 to 6 **characterised in that** the hydrocarbon gas or fluorinated hydrocarbon gas is selected from the group comprising methane, acetylene, difluoromethane and tretrafluoromethane.

**8.** Method of any of the claims 1 to 7, **characterised in that** by changing the composition individual layers are generated, which act as diffusion barriers and/or adhesive agent within the coating and/or in respect to the support to be coated.

## Revendications

**1.** Procédé pour revêtir un support métallique, respectivement un substrat métallique, d'une couche mince lors de la fabrication d'un collecteur solaire, le revêtement étant obtenu au moyen d'un procédé combiné CVD/PVD comportant une déposition en phase gazeuse activée par plasma à partir d'un hydrocarbure gazeux respectivement d'un hydrocarbure gazeux fluoré et la formation d'un revêtement contenant un hydrocarbure amorphe ou un hydrocarbure amorphe fluoré, et une pulvérisation par sputtering d'une cible en chrome de manière à déposer plusieurs couches dont la teneur en chrome varie par paliers et/ou au moins une couche dont la teneur en chrome varie au moins de façon quasi-continue, **caractérisé en ce que** pendant la déposition le support, respectivement le substrat, est maintenu par une source de tension continue (10) à un potentiel électrique négatif pour réaliser une énergie maximale des ions extraits du plasma, **en ce que** le support est une tôle de cuivre, et **en ce que** la teneur en chrome de la couche exprimée en nombre d'atomes diminue de plus de 50 % à moins de 30 % de la surface du substrat jusqu'à la surface externe de la couche.

**2.** Procédé selon la revendication 1, **caractérisé en ce que** le revêtement est obtenu sous vide dans une installation de déposition évacuée (1), la composition de la couche étant modifiée au cours de la croissance par variation dans l'installation de déposition de la concentration du courant volumétrique d'hydrocarbure, respectivement d'hydrocarbure fluoré, dans un courant volumétrique de gaz inerte.

**3.** Procédé selon une des revendications précédentes, **caractérisé en ce que** l'on modifie la composition de la couche au cours de la croissance par modification ou variation du potentiel négatif du substrat, respectivement du support.

**4.** Procédé selon une des revendications 1 à 3, **caractérisé en ce que** l'on chauffe le support, respectivement le substrat, pendant le dépôt de la couche.

**5.** Procédé selon une des revendications 1 à 4, **caractérisé en ce que** l'on diminue la teneur en métal de la couche lorsqu'on s'éloigne de la surface du substrat, respectivement du support, en direction de la surface de la couche, par utilisation d'un courant volumétrique d'hydrocarbure, tel un hydrocarbure fluoré, plus faible au début du dépôt de la couche, ce courant volumétrique étant ensuite augmenté soit par paliers, soit de façon continue, et/ou en diminuant le potentiel électrique appliqué au support, respectivement au substrat, au cours du processus de déposition.

**6.** Procédé selon une des revendications 1 à 5, **caractérisé en ce qu'**un revêtement est déposé sous vide sur la tôle de cuivre dans une installation de déposition en pulvérisant par spufttering cathodique une cible formant une cathode en chrome ou en un alliage de chrome, et en introduisant dans l'installation un gaz inerte ou porteur, tel par exemple de l'argon, chargé d'un hydrocarbure, tel par exemple du méthane, un courant alternatif de haute fréquence étant simultanément transmis à la cathode par l'intermédiaire d'un couplage capacitif ou inductif.

**7.** Procédé selon une des revendications 1 à 6, **caractérisé en ce que** l'hydrocarbure, respectivement l'hydrocarbure fluoré, est choisi dans le groupe comprenant le méthane, l'acétylène, le di-fluoro-méthane et le tetra-fluoro-méthane.

**8.** Procédé selon une des revendications 1 à 7, **caractérisé en ce que** l'on obtient par modification de la composition des couches individuelles agissant comme barrières de diffusion et/ou comme facteur d'adhésion à l'intérieur de la couche et/ou entre celle-ci et le support à revêtir.

Figur 1

Figur 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4309261 A

**In der Beschreibung aufgeführte Nicht-Patentliteratur**

- **B. CARLSSON et al.** Accelarated Life Testing of Solar Energy Materials. *Case study of some selective solar absorber coating materials for DHW Systems,* Februar 1994
- **B. N. CHAPMAN.** *Glow discharge processes,* 215-221
- **P.J. PIGRAM ; R.N. LAMB ; B.J. WOOD ; R.E. COLLINS.** *Structure and Surface Composition of Solar Selective Graded Stainless Steel/Carbon,* 1991, vol. 52, 145-150